# FASCICULE DE BREVET EUROPEEN

(11) **EP 4 506 995 B1**
(45) Date de publication et mention de la délivrance du brevet: **15.04.2026**
(21) Numéro de dépôt: 24193282.1
(22) Date de dépôt: 07.08.2024
(51) Int. Cl.: H10H 29/01, H10H 29/30

(54) **PROCEDE DE FABRICATION D'UN DISPOSITIF OPTOELECTRONIQUE A CONVERSION DE COULEUR, COMPORTANT UNE ETAPE DE FORMATION PAR VOIE OPTIQUE DE MOTIFS DE POTENTIEL DE SURFACE DANS UNE COUCHE ELECTRET**
VERFAHREN ZUR HERSTELLUNG EINER OPTOELEKTRONISCHEN FARBKONVERSIONSVORRICHTUNG MIT EINEM SCHRITT ZUR OPTISCHEN FORMUNG VON OBERFLÄCHENPOTENTIALMUSTERN IN EINER ELEKTRETSCHICHT
METHOD FOR MANUFACTURING A COLOR-CONVERTING OPTOELECTRONIC DEVICE, COMPRISING A STEP OF OPTICALLY FORMING SURFACE POTENTIAL PATTERNS IN AN ELECTRET LAYER

(30) Priorité: 10.08.2023 FR 2308637
(43) Date de publication de la demande: 12.02.2025
(73) Titulaire: Commissariat à l'Energie Atomique et aux Energies Alternatives, 75015 Paris (FR)
(72) Inventeur: ALTAZIN, Stéphane, 38054 Grenoble cedex 09 (FR); QUESNEL, Etienne, 38054 Grenoble cedex 09 (FR); SUHM, Aurélien, 38054 Grenoble cedex 09 (FR); BILDE, Jérémy, 38054 Grenoble cedex 09 (FR)
(74) Mandataire: Santarelli

(56) Documents cités:
- WO-A1-2021/076724
- WO-A2-2015/186074
- US-A- 3 276 031
- US-A1- 2022 282 152

## Description

### DOMAINE TECHNIQUE

Le domaine de l'invention est celui des procédés de fabrication des dispositifs optoélectroniques comportant une matrice de diodes d'émission ou de détection d'un rayonnement électroluminescent, associée à une structure de conversion de couleur à plots photoluminescents. L'invention trouve une application en particulier dans les écrans d'affichage et les projecteurs d'images.

### ÉTAT DE LA TECHNIQUE ANTÉRIEURE

Il existe des dispositifs optoélectroniques comportant une matrice de diodes électroluminescentes identiques recouverte au moins en partie par des plots photoluminescents assurant une conversion de couleur. De tels dispositifs optoélectroniques peuvent former des écrans d'affichage ou des systèmes de projection d'images comportant une matrice de pixels lumineux de différentes couleurs.

Dans un tel dispositif optoélectronique, chaque pixel lumineux comportant une ou plusieurs diodes électroluminescentes associées à un plot photoluminescent. Dans le but d'obtenir des pixels lumineux adaptés à émettre des rayonnements lumineux de différentes couleurs, par exemple bleues, vertes ou rouges, les diodes électroluminescentes peuvent être adaptées à émettre toute une même lumière, par exemple bleue, et les pixels verts et rouges comportent des plots photoluminescents adaptés à absorber au moins en partie la lumière bleue incidente émise par les diodes électroluminescentes, et à émettre en réponse une lumière verte ou une lumière rouge.

Les diodes électroluminescentes sont donc de préférence identiques entre elles, et émettent un rayonnement lumineux sensiblement de même longueur d'onde. Elles peuvent être formées à base d'un matériau semiconducteur comprenant des éléments de la colonne III et de la colonne V du tableau périodique, tel qu'un composé III-V, notamment le nitrure de gallium (GaN), le nitrure d'indium et de gallium (InGaN) ou le nitrure d'aluminium et de gallium (AlGaN). Elles sont agencées de manière à former une matrice de diodes électroluminescentes présentant une face avant au travers de laquelle est transmis le rayonnement lumineux généré. Il peut également s'agir de diodes électroluminescentes organiques.

Les plots photoluminescents peuvent être formés d'une matrice liante comportant des particules d'un matériau photoluminescent tel que le grenat d'yttrium et d'aluminium (YAG, pour *Yttrium Aluminium Garnet,* en anglais) activé par l'ion cérium YAG:Ce. Les particules photoluminescentes peuvent également être des boîtes quantiques (*quantum dots,* en anglais), c'est-à-dire sous la forme de nanocristaux semiconducteurs dont le confinement quantique est sensiblement tridimensionnel. Il peut également s'agir, notamment, de cristaux d'InP, de pérovskite ou de CdSe.

Le procédé de fabrication peut comporter le dépôt puis la structuration d'une couche photoluminescente pour former des premiers plots photoluminescents, par exemple adaptés à convertir le bleu en vert. Ces étapes sont effectuées à nouveau pour former des deuxièmes plots photoluminescents, par exemple adaptés à convertir le bleu en rouge. Cependant, ce procédé présente l'inconvénient d'être peu adapté aux matrices de diodes à faible pas de pixels, par exemple de l'ordre de 5 µm, dans la mesure où des problèmes d'alignement ou de recouvrement des plots photoluminescents les uns par les autres peuvent être présents.

Le document WO2014/136023 décrit un autre procédé de fabrication, qui utilise une couche électret recouvrant la matrice de diodes. Le procédé comprend tout d'abord une étape d'inscription de motifs de charges électriques sur la face supérieure d'une couche diélectrique pour obtenir la couche électret. Pour cela, une pointe AFM polarisée est utilisée pour injecter localement les charges électriques. Puis, on effectue une étape de dépôt localisé de nanocristaux colloïdaux sur les motifs de charges électriques. Pour cela, la couche électret est mise au contact d'une solution colloïdale contenant les nanocristaux, lesquels viennent se déposer naturellement sur les motifs de charges électriques sous l'effet d'une force diélectrophorétique. Cependant, ce procédé présente notamment l'inconvénient de devoir d'injecter les charges électriques de manière séquentielle, en déplaçant la point AFM sur la surface de la face supérieure pour y former les motifs de charges électriques.

Le document WO2021/023656 décrit un procédé similaire, où les motifs de charges électriques sont définis par une technique d'estampage, c'est-à-dire par la mise au contact, avec une couche diélectrique destinée à former la couche électret, d'un tampon polarisé électriquement. La face inférieure du tampon est structurée pour former des dents polarisées, lesquelles viennent au contact de la couche diélectrique. On obtient ainsi la couche électret dont la face supérieure présente les motifs de charges électriques. Ensuite, on met la couche électret au contact d'une solution colloïdale, les nanocristaux présents se déposant alors sur les motifs de charges électriques par diélectrophorèse. Cependant, ce procédé présente notamment l'inconvénient de devoir positionner précisément le tampon vis-à-vis de la matrice de diodes. Or, l'incertitude de positionnement du tampon vis-à-vis de la matrice de diodes peut devenir problématique, en particulier pour les matrices de diodes à petit pas pixel, par exemple de l'ordre de 5 µm. En effet, cette incertitude de positionnement peut conduire à un mauvais positionnement des plots photoluminescents vis-à-vis des diodes, et donc à une dégradation des performances du dispositif optoélectronique.

WO 2021/076724 divulgue un procédé de fabrication d'un dispositif optoélectronique selon l'état de la technique.

US 2022/282152 divulgue un procédé de fabrication d'un dispositif d'affichage électroluminescent au moyen d'une couche électret selon l'état de la technique.

US 3276031 divulgue la déformation d'une couche électret à l'aide d'une lumière de dépolarisation.

WO 2015/186074 divulgue l'inscription d'images dans une couche électret.

### EXPOSÉ DE L'INVENTION

L'invention a pour objectif de remédier au moins en partie aux inconvénients de l'art antérieur, et plus particulièrement de proposer un procédé de fabrication d'un dispositif optoélectronique, où la formation des motifs de charges électriques, que l'on appellera ici motifs de potentiel de surface, est effectuée dans une couche électret par voie optique, soit par une polarisation localisée de la couche électret, soit par une dépolarisation localisée de la couche électret. Cette étape permet de réaliser simultanément tous les motifs de potentiel de surface dans la couche électret, sans nécessiter d'utiliser une pointe AFM ou un tampon comme décrit précédemment, et donc de réaliser des plots photoluminescents qui présentent un bon positionnement vis-à-vis de la matrice de diodes.

Pour cela, l'objet de l'invention est un procédé de fabrication d'un dispositif optoélectronique comportant : une matrice de diodes, adaptées à émettre ou recevoir un rayonnement lumineux ; et une structure de conversion de couleur, recouvrant au moins en partie la matrice de diodes, et contenant des plots photoluminescents disposés chacun en regard d'au moins une diode.

Le procédé de fabrication comporte les étapes suivantes :
∘ A/ fournir la matrice de diodes ;
∘ B/ réaliser une couche électret, recouvrant la matrice de diodes, et dont une face supérieure, opposée à la matrice de diodes, présente des motifs de potentiel de surface prédéfinis où le potentiel de surface est non nul ;
o C/ réaliser les plots photoluminescents, par mise en contact de la couche électret avec une solution colloïdale contenant des particules photoluminescentes, lesquelles se déposent alors sur la face supérieure de la couche électret en regard des motifs de potentiel de surface prédéfinis, formant ainsi les plots photoluminescents.

Selon l'invention, l'étape B de réalisation de la couche électret comporte les étapes suivantes :
- B1/ réaliser une couche électret dont la face supérieure présente, sur toute sa surface, un potentiel de surface initial non nul ou nul ; puis
- B2a/ dans le cas où le potentiel de surface initial est non nul : éclairer des zones de la couche électret par un rayonnement lumineux dit de dépolarisation apte à être absorbé au moins en partie par la couche électret, lesdites zones éclairées étant distinctes de zones non éclairées destinées à former les motifs de potentiel de surface, l'absorption du rayonnement lumineux de dépolarisation dans les zones éclairées provoquant une annulation du potentiel de surface local, les zones non éclairées définissant alors les motifs de potentiel de surface ;
- B2b/ ou, dans le cas où le potentiel de surface initial est nul : éclairer des zones de la couche électret par un rayonnement lumineux dit de polarisation apte à être absorbé au moins en partie par la couche électret, l'absorption du rayonnement lumineux de polarisation dans les zones éclairées provoquant une formation d'un potentiel de surface local non nul, les zones éclairées définissant alors les motifs de potentiel de surface.

Certains aspects préférés mais non limitatifs de ce procédé sont les suivants.

Le procédé peut comporter, au préalable de l'étape B2a ou B2b, une étape de disposition d'un masque opaque, en un matériau opaque au rayonnement lumineux de dépolarisation ou de polarisation, s'étendant uniquement sur les zones de la couche électret destinées à former les motifs de potentiel de surface ; puis, lors de l'étape B2a ou B2b, le rayonnement lumineux de dépolarisation ou de polarisation peut être émis en direction du masque opaque et de la couche électret, et est absorbé par la couche électret dans les zones non recouvertes par le masque opaque.

Les diodes peuvent être des diodes électroluminescentes. La couche électret peut être réalisée en un matériau adapté à absorber partiellement le rayonnement lumineux émis par les diodes électroluminescentes, ce qui provoque une annulation du potentiel de surface local. Lors de l'étape B2a, des diodes peuvent être activées sélectivement de manière à éclairer la couche électret dans les zones destinées à ne pas former les motifs de potentiel de surface, ce qui provoque une annulation du potentiel de surface local, les zones non éclairées définissant alors les motifs de potentiel de surface. Ou, lors de l'étape B2b, des diodes peuvent être activées sélectivement de manière à éclairer la couche électret uniquement dans les zones destinées à former les motifs de potentiel de surface.

En lien avec l'étape B2a, la couche électret peut être réalisée en un matériau diélectrique organique auto-polarisé, de sorte que l'étape B1 peut alors consister à déposer la couche électret recouvrant la matrice de diodes, la couche électret présentant alors, sur toute sa surface, un potentiel de surface initial non nul.

En lien avec l'étape B2b, la couche électret peut être réalisée en un matériau diélectrique photochromique, de sorte que l'étape B1 peut alors consister à déposer une couche électret, en le matériau diélectrique photochromique, recouvrant la matrice de diodes, la couche électret présentant alors, sur toute sa surface, un potentiel de surface nul.

En lien avec l'étape B2a, la couche électret peut être réalisée en un matériau diélectrique, de sorte que l'étape B1 peut comporter les étapes suivantes : déposer une couche électret, en le matériau diélectrique, recouvrant la matrice de diodes, la couche électret présentant alors, sur toute sa surface, un potentiel de surface initial nul ; puis soumettre la couche électret à un champ électrique dit de polarisation prédéfini, provoquant une formation d'un potentiel de surface non nul sur toute la surface de la couche électret.

La matrice de diodes peut comporter une couche électrode supérieure recouvrant les diodes et adaptée à polariser électriquement les diodes. Lors de l'étape de soumission de la couche électret au champ électrique de polarisation, la couche électret peut alors être disposée alors entre la couche électrode supérieure et une électrode rapportée, entre lesquelles est appliquée une différence de potentiel prédéfinie.

La couche électret réalisée lors de l'étape B peut être une première couche électret. Les plots photoluminescents réalisés lors de l'étape C peuvent alors être des premiers plots photoluminescents adaptés à convertir un rayonnement lumineux incident d'une première longueur d'onde en un rayonnement lumineux d'une deuxième longueur d'onde différente de la première longueur d'onde.

Le procédé peut alors comporter les étapes suivantes, à la suite de l'étape C :
o D/ réaliser une deuxième couche électret, recouvrant la matrice de diodes et la première couche électret, et dont une face supérieure, opposée à la matrice de diodes, présente des deuxièmes motifs de potentiel de surface prédéfinis où le potentiel de surface est non nul, lesdits deuxièmes motifs de potentiel de surface étant situés en regard de diodes distinctes de celles en regard desquelles sont situés les premiers motifs de potentiel de surface ;
o E/ réaliser les deuxièmes plots photoluminescents, par mise en contact de la deuxième couche électret avec une solution colloïdale contenant des deuxièmes particules photoluminescentes, différentes des premières particules photoluminescentes de l'étape C, qui se déposent alors sur la face supérieure de la deuxième couche électret en regard des deuxièmes motifs de potentiel de surface prédéfinis, formant ainsi les deuxièmes plots photoluminescents.

Les diodes de la matrice peuvent être des diodes électroluminescentes adaptées à émettre un rayonnement lumineux à une même longueur d'onde. Elles peuvent alors former, avec les premiers et deuxièmes plots photoluminescents, une matrice de pixels lumineux rouges, verts, bleus.

La matrice de diodes peut présenter une dimension, dans un plan parallèle à la matrice de diodes (10), supérieure ou égale à 100mm.

La matrice de diodes peut présenter un pas de périodicité inférieure ou égale à 10µm, voire à 5µm, voire à 2µm.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
les figures 1A à 1H illustrent différentes étapes d'un procédé de fabrication d'un dispositif optoélectronique, où au moins l'une des couches électrets est réalisée en un matériau diélectrique auto-polarisé ;
les figures 2A à 2C illustrent différentes étapes d'une variante du procédé de fabrication d'un dispositif optoélectronique, où la dépolarisation localisée est effectuée au moyen de diodes, de la matrice de diodes, activées sélectivement ;
les figures 3A à 3C illustrent différentes étapes d'une variante du procédé de fabrication d'un dispositif optoélectronique, où la couche électret est réalisée en un matériau diélectrique photochromique qui est polarisé électriquement par voie optique localement ;
les figures 4A à 4F illustrent différentes étapes d'une variante du procédé de fabrication d'un dispositif optoélectronique, où au moins l'une des couches électrets est réalisée en un matériau diélectrique qui est polarisé électriquement par voie électrostatique.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un procédé de fabrication d'un dispositif optoélectronique comportant une matrice de diodes recouverte par une structure de conversion de couleur à plots photoluminescents. La réalisation des plots photoluminescents est obtenue par le dépôt de particules photoluminescentes sur des motifs de potentiel de surface d'une face supérieure d'une couche électret. Comme détaillé par la suite, les motifs de potentiel de surface sont définis en dépolarisant localement, ou en polarisant localement, la couche électret par voie optique. Par ailleurs, les diodes peuvent être des diodes émissives (par exemple diodes électroluminescentes) ou être des photodiodes.

D'une manière générale, une couche électret est une couche diélectrique contenant des charges électriques fixes ou une polarisation dipolaire quasi-permanente. Aussi, la couche électret présente, sur sa face supérieure, un potentiel de surface non nul. Cela se traduit par le fait que la couche électret génère un champ électrique externe en l'absence d'un champ appliqué. Par extension, on appellera également 'couche électret' une couche diélectrique présentant initialement, sur toute sa surface, un potentiel de surface nul, et qui est destinée à former une couche électret présentant des motifs de potentiel de surface.

Dans le cadre de l'invention, on met à profit le fait qu'une couche électret peut être dépolarisée par l'absorption d'un rayonnement lumineux dit de dépolarisation, comme l'expliquent l'article de Sugi et al. intitulé Characterization of light-erasable giant surface potential built up in evaporated Alq3 thin films, Thin Solid Films 464-465 (2004), 412-415, et l'article de Tanaka et al. intitulé Self-Assembled Electret for Vibration-Based Power Generator, Sci Rep 10, 6648 (2020). Une telle dépolarisation se traduit alors par une annulation du potentiel de surface de la couche électret. En effet, l'absorption du rayonnement lumineux de dépolarisation se traduit par la création de paires électrons-trous qui, selon une approche, viennent compenser la polarisation de charges, ce qui se traduit par une annulation du potentiel de surface. Par ailleurs, une couche électret peut également être polarisée par l'absorption d'un rayonnement lumineux dit de polarisation.

Ainsi, comme détaillé par la suite, selon un mode de réalisation, on réalise tout d'abord une couche électret qui présente initialement, sur toute sa surface, un potentiel de surface non nul. Puis on dépolarise des zones prédéfinies de la couche électret, en les éclairant par un rayonnement lumineux de dépolarisation apte à être absorbé au moins en partie par la couche électret. Les zones éclairées présentent alors un potentiel de surface nul, alors que les zones non éclairées gardent leur potentiel de surface non nul, et forment ainsi les motifs de potentiel de surface où viendront ensuite, lors de l'étape suivante, se déposer de manière localisée les particules photoluminescentes par diélectrophorèse. Aussi, les plots photoluminescents sont naturellement situés en regard (c'est-à-dire « à la perpendiculaire ») des motifs de potentiel de surface, et non pas hors de ces motifs prédéfinis. Ce procédé permet alors de définir de manière précise les motifs de potentiel de surface sur la face supérieure de la couche électret, quand bien même la matrice de diodes présente une dimension importante (notamment lorsqu'elle est réalisée en technologie de wafer 100 mm ou 200 mm) et/ou que le pas pixel de la matrice de diodes est petit (par exemple de l'ordre de 5 µm ou moins, par exemple 2µm).

Par ailleurs, selon un autre mode de réalisation, on réalise tout d'abord une couche électret qui présente initialement, sur toute sa surface, un potentiel de surface nul. Puis on polarise des zones prédéfinies de la couche électret, en les éclairant par un rayonnement lumineux de polarisation apte à être absorbé au moins en partie par la couche électret. Les zones éclairées présentent alors un potentiel de surface non nul (alors que les zones non éclairées gardent leur potentiel de surface nul), et forment ainsi les motifs de potentiel de surface où viendront ensuite, lors de l'étape suivante, se déposer de manière localisée les particules photoluminescentes par diélectrophorèse. Ce procédé permet, comme précédemment, de définir de manière précise les motifs de potentiel de surface sur la face supérieure de la couche électret.

Par ailleurs, les plots photoluminescents sont adaptés à convertir au moins en partie un rayonnement lumineux incident d'une première longueur d'onde λ₁ en un rayonnement lumineux de luminescence de plus grande longueur d'onde λ₂. A titre illustratif, elles peuvent être adaptées à absorber de la lumière bleue, c'est-à-dire dont la longueur d'onde est comprise entre 440nm et 490nm environ, et à émettre dans le vert, c'est-à-dire à une longueur d'onde comprise entre 495nm et 560nm environ, voire dans le rouge, c'est-à-dire à une longueur d'onde comprise entre 600nm et 650nm, voire encore dans l'infrarouge. Par longueur d'onde, on entend ici la longueur d'onde pour laquelle le spectre d'émission présente un pic d'intensité. A titre purement illustratif, les diodes électroluminescentes peuvent présenter un spectre d'émission dont le pic d'intensité est compris entre 380nm et 490nm. Dans le cas d'une matrice de diodes électroluminescentes, le rayonnement lumineux incident est le rayonnement émis par les diodes, alors que dans le cas de photodiodes, il s'agit du rayonnement lumineux provenant d'un environnement extérieur et dirigé vers les photodiodes. Notons que dans le cas de photodiodes, les plots photoluminescents permettent de filtrer une partie de la gamme spectrale du rayonnement lumineux incident, dans le but par exemple de procéder à une analyse spectrale.

Les plots photoluminescents sont formés de particules en au moins un matériau photoluminescent, et de préférence des nanoparticules dont une dimension maximale est comprise entre 0.2nm et 1000nm, par exemple comprise entre 0.2nm et 100nm, et par exemple entre 1nm et 30nm. La taille et/ou la composition des particules photoluminescentes sont choisies en fonction de la longueur d'onde de luminescence désirée. La forme des particules peut être quelconque, par exemple sphérique, anguleuse, aplatie, allongée...

Les particules photoluminescentes peuvent être des boîtes quantiques (*quantum dots,* en anglais), c'est-à-dire des nanocristaux semiconducteurs dont le confinement quantique est sensiblement tridimensionnel, voire des agrégats de boîtes quantiques. La taille moyenne des boîtes quantiques peut alors être comprise entre 0,2nm et 50nm, par exemple entre 1nm et 30nm. Il peut également s'agir de nanoplaquettes (*nanoplatelets,* en anglais), c'est-à-dire des nanoparticules ayant une forme essentiellement bidimensionnelle. Aussi, la plus petite dimension (épaisseur) est inférieure aux deux autres dimensions de longueur et de largeur, de préférence d'un rapport au moins 1.5.

Les particules photoluminescentes peuvent notamment être formées d'au moins un composé semiconducteur, qui peut être choisi, par exemple, parmi le séléniure de cadmium (CdSe), le phosphore d'indium (InP), le phosphore de gallium et d'indium (InGaP), le sulfure de cadmium (CdS), le sulfure de zinc (ZnS), l'oxyde de cadmium (CdO) ou de zinc (ZnO), le séléniure de zinc et de cadmium (CdZnSe), le séléniure de zinc (ZnSe) dopé par exemple au cuivre ou au manganèse, le graphène ou parmi d'autres matériaux semiconducteurs pouvant convenir. Les nanoparticules peuvent également présenter une structure de type cœur/coquille, tel que CdSe/ZnS, CdSe/CdS, CdSe/CdS/ZnS, PbSe/PbS, CdTe/CdSe, CdSe/ZnTe, InP/ZnS ou autre.

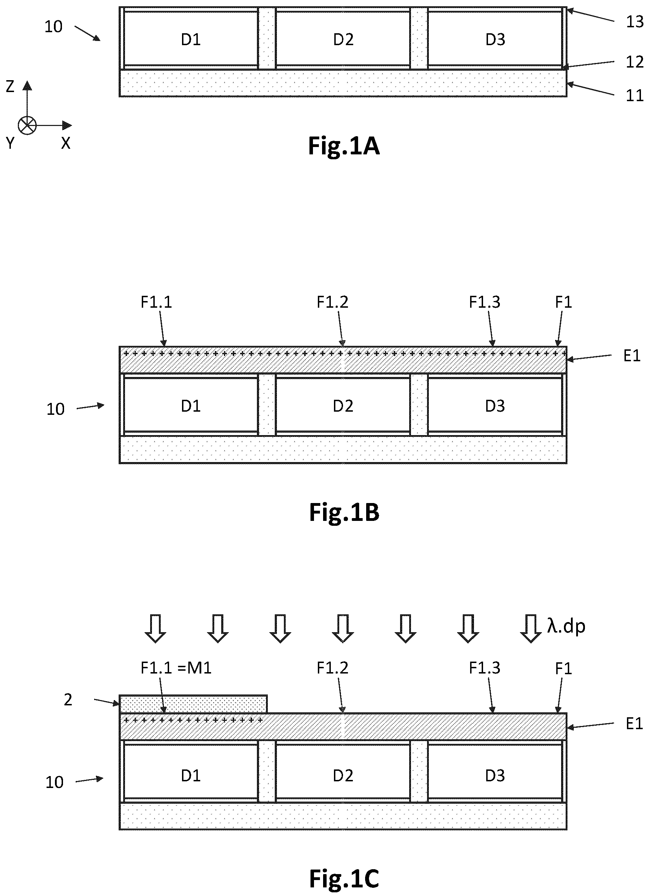

Les figures 1A à 1H illustrent différentes étapes d'un procédé de fabrication d'un dispositif optoélectronique 1 selon un mode de réalisation. Dans cet exemple, au moins l'une des couches électrets E1, E2, et ici les deux couches électrets, sont réalisées en un matériau diélectrique auto-polarisé. Dans cet exemple, les motifs de potentiel de surface sont réalisés par dépolarisation localisée, par voie optique, d'une couche électret présentant initialement, sur toute sa surface, un potentiel de surface non nul.

Par ailleurs, le dispositif optoélectronique 1 comporte une matrice de pixels lumineux de type RVB (rouge, vert, bleu). Chaque pixel RGB est formé ici de plusieurs sous-pixels lumineux de type R, G ou B, comportant chacun au moins une diode électroluminescente (une diode par sous-pixel). Dans la description, on appelle « pixel » un sous-pixel associé à une couleur donnée. En variante, le dispositif optoélectronique 1 pourrait comporter une matrice de photodiodes.

On définit ici et pour la suite de la description un repère direct tridimensionnel orthogonal XYZ, où les axes X et Y forment un plan principal dans lequel s'étend un substrat support 11, et où l'axe Z est orienté suivant l'épaisseur de la matrice de diodes 10 en direction de la face avant. Les termes 'inférieur' et 'supérieur' sont définis par rapport à un positionnement croissant suivant la direction +Z.

En référence à la fig.1A, on fournit une matrice de diodes électroluminescentes 10. Dans cet exemple, les diodes sont réparties en trois types notés D1, D2, D3, selon qu'elles sont destinées à former des pixels P1, P2, P3 de couleurs différentes. Les diodes reposent ici sur un substrat support 11, et sont polarisées électriquement ici par une couche d'électrode inférieure 12 et par une couche d'électrode supérieure 13. D'autres configurations sont possibles, notamment dans le cas où le substrat support 11 est électriquement conducteur.

Les diodes D1, D2, D3 sont réalisées ici de manière classique, par exemple par épitaxie de couches semiconductrices. Chaque diode D1, D2, D3 est formée d'un empilement d'une portion semiconductrice inférieure dopée d'un premier type de conductivité, par exemple de type p, d'une zone active où est émis le rayonnement lumineux de la diode électroluminescente, et d'une portion semiconductrice supérieure dopée d'un deuxième type de conductivité, par exemple de type n. Les diodes D1, D2, D3 peuvent être réalisées à partir d'un même composé semiconducteur, par exemple à base d'un composé III-V tel que du GaN, InGaN, AlGaN entre autres.

De préférence, les diodes D1, D2, D3 sont structurellement identiques, de sorte que le rayonnement lumineux émis est sensiblement identique d'une diode à l'autre en termes de longueur d'onde. Dans cet exemple, les diodes D1, D2, D3 sont adaptées à émettre un rayonnement lumineux dans le bleu, c'est-à-dire dont le spectre d'émission présente un pic d'intensité à une longueur d'onde comprise entre 440nm et 490nm environ.

Une face avant de la matrice de diodes 10 est une face sensiblement plane, moyennant la présence éventuelle de micro-structurations de surface permettant d'améliorer l'extraction de lumière. Elle est formée ici de la face supérieure de la couche d'électrode supérieure 13 adaptée à polariser électriquement les diodes. Elle peut également être formée par une couche mince de passivation (non représentée) qui recouvre les diodes et la couche d'électrode supérieure.

En référence aux fig.1B et 1C, on réalise ensuite une première couche électret E1, qui recouvre au moins en partie la matrice de diodes 10, et dont la face supérieure F1 présente des premiers motifs de potentiel de surface M1 où le potentiel de surface est non nul. Ces motifs M1 sont entourés, au moins en partie, par des zones de la face supérieure F1 où le potentiel de surface est nul. Comme indiqué précédemment, une couche électret présente un potentiel de surface non nul au niveau de sa face supérieure du fait de la présence de charges électriques ou d'une polarisation dipolaire (orientation verticale des dipôles). Ici, le potentiel de surface de la face supérieure F1 est non nul seulement dans des motifs prédéfinis M1, appelés motifs de potentiel de surface, alors qu'il est sensiblement nul hors de ces motifs M1. Il peut être d'une valeur de 10V environ. Les motifs de potentiel électrique M1 sont donc les surfaces de la face supérieure où le potentiel électrique est non nul. Ils s'étendent en regard d'au moins une diode, et sont destinés à former les surfaces où viendront se déposer des particules photoluminescentes lors de la réalisation des plots photoluminescents.

En référence à la fig.1B, on dépose une couche électret E1 qui recouvre au moins en partie la matrice de diodes 10. Dans cet exemple, la couche électret E1 est réalisée en un matériau diélectrique auto-polarisé, c'est-à-dire qu'il n'a pas été nécessaire de polariser la couche diélectrique par une étape dédiée. Elle forme donc une couche électret dont la face supérieure F1 présente, sur toute sa surface, un potentiel de surface initial non nul. Par sur toute sa surface, on entend au moins sur toute la surface de la face supérieure de la couche électret qui est en regard de la matrice de diodes. Dans cet exemple, la couche électret E1 recouvre l'ensemble des diodes D1, D2 et D3 mais pourrait ne recouvrir qu'une partie des diodes, par exemple uniquement celles destinées à former les pixels rouges et les pixels verts. Sa face supérieure présente plusieurs zones F1.1, F1.2 et F1.3, situées respectivement en regard des diodes D1, D2 et D3.

Par ailleurs, le matériau de la couche électret E1 est choisi pour être au moins en partie absorbant à la longueur d'onde d'un rayonnement lumineux de dépolarisation (par exemple dans l'ultra-violet), et au moins en partie transparent à la longueur d'onde du rayonnement lumineux émis par les diodes (par exemple dans le bleu). Par « au moins en partie absorbant », on entend que le taux d'absorption est d'au moins 20% (voire moins, par exemple au moins 10%), voire d'au moins 50%, à la longueur d'onde du rayonnement lumineux de dépolarisation. Et par « au moins en partie transparent », on entend que le taux de transmission est d'au moins 50% à la longueur d'onde du rayonnement lumineux émis par les diodes. La couche électret peut présenter une épaisseur de quelques dizaines à centaines de nanomètres, et de préférence au plus égale à 2µm.

A titre d'exemple, le matériau diélectrique auto-polarisé peut être un matériau organique choisi parmi le BCPO (bis-4-(N-carbazolyl)phenyl)phenylphosphine oxide), le DPEPO (bis[2-(diphenylphosphino)phenyl]ether oxide), le mCBP-CN (3,3'-di(carbazol-9-yl)-5-cyano-1,1'-biphenyl) et le PO9 (3,6-bis(diphenylphosphoryl)-9-phenylcarbazole).

Il peut également être un matériau organique choisi parmi : le TPBi (2,2',2"-(1,3,5-Benzinetriyl)-tris(1-phenyl-1-H-benzimidazole)), le o-ethyl-TPB, le m-ethyl-TPBi, le p-ethyl-TPBi, le Alq3 (tris(8-hydroxyquinolinato)aluminum), le Al(7-Prq)3 (tris(7-propyl-8-hydroxyquinolinolato) aluminum(III)), le Al(q-Cl)3 (tris(5-chloro-8-hydroxyquinolinato)aluminum), le OXD-7 (2,2'-(1,3-phenylene)-bis[5-(4-tert-butylphenyl)-1,3,4-oxadiazole]), le BCP (2,9-dimethyl-4,7-diphenyl-1,10-phenanthroline), le Gaq3 (tris(8-hydroxyquinoline) gallium), le Balq (bis(2-methyl-8-quinolinate)4-phenylphenolate), le Ir(ppy)3 (tris(2-phenylpyridine)iridium(III)), le Ir(ppy)2acac (bis(2-phenylpyridine)iridium(III) acetylacetonate), le Ir(ppy)2tmd (bis(2-phenylpyridine)iridium(III)(2,2,6,6-tetramethylheptane-3,5-diketonate)), le Bpy-OXD (1,3-Bis[2-(2,2'-bipyridine-6-yl)-1,3,4-oxadiazo-5-yl]benzene), le 2CzPN (4,5-di (9H-carbazol-9-yl) phthalonitrile), le 1,2,3,5-tetrakis(carbazol-9-yl)-4,6-dicyanobenzene, le 4CzPN (3,4,5,6-tetrakis (carbazol-9-yl)-1,2-dicyanobenzene), le DCJTB (4-(dicyanomethylene)-2-t-butyl-6-(1,1,7,7-tetramethyljulolidyl-9-enyl)-4H-pyran), le DACT-II (9-[4-(4,6-diphenyl-1,3,5-triazin-2-yl)phenyl]-N,N,N',N'-tetraphenyl-9H-carbazole-3,6-diamine), le mCP (1,3-Bis(N-carbazolyl)benzene), le α-NPD (N,N'-bis(1-naphthyl)-N,N'-diphenyl-1,1'-biphenyl-4,4'-diamine), le Znq2 (bis(8-hydroxyquinoline)zinc), et le B3PyMPM (bis-4,6-(3,5- di-3-pyridylphenyl)-2-methylpyrimidine).

En référence à la fig.1C, on dépolarise localement la couche électret E1 par voie optique de manière à définir les premiers motifs de potentiel de surface M1. Pour cela, on dépose ici une couche opaque sur la couche électret E1, que l'on structure ensuite par photolithographie et gravure pour obtenir un masque opaque 2 qui ne s'étend ici qu'en regard des diodes D1, c'est-à-dire sur les seules zones F1.1. Il ne s'étend donc pas en regard des diodes D2 et D3. Le masque opaque 2 peut être réalisé en une résine photosensible opaque au rayonnement lumineux de dépolarisation, ici à l'ultra-violet. En variante, le masque opaque 2 peut être le masque de photolithographie au niveau du stepper.

Ensuite, on soumet la couche électret E1 au rayonnement lumineux de dépolarisation, de longueur d'onde À.dp, qui est alors absorbé par la couche électret E1 uniquement dans les zones F1.2 et F1.3 (non recouvertes par le masque opaque 2), et non pas dans les zones F1.1. Aussi, l'absorption du rayonnement lumineux de dépolarisation provoque une dépolarisation localisée dans les zones F1.2 et F1.3 de la face supérieure F1 de la couche électret E1. Les zones F1.1 de la face supérieure F1 de la couche électret E1 forment donc les motifs de potentiel de surface M1. A titre d'exemple, le rayonnement lumineux de dépolarisation peut être dans l'ultra-violet, c'est-à-dire à une longueur d'onde principale comprise entre 100 et 380nm. A la suite de cette étape, la résine 2 est ici retirée.

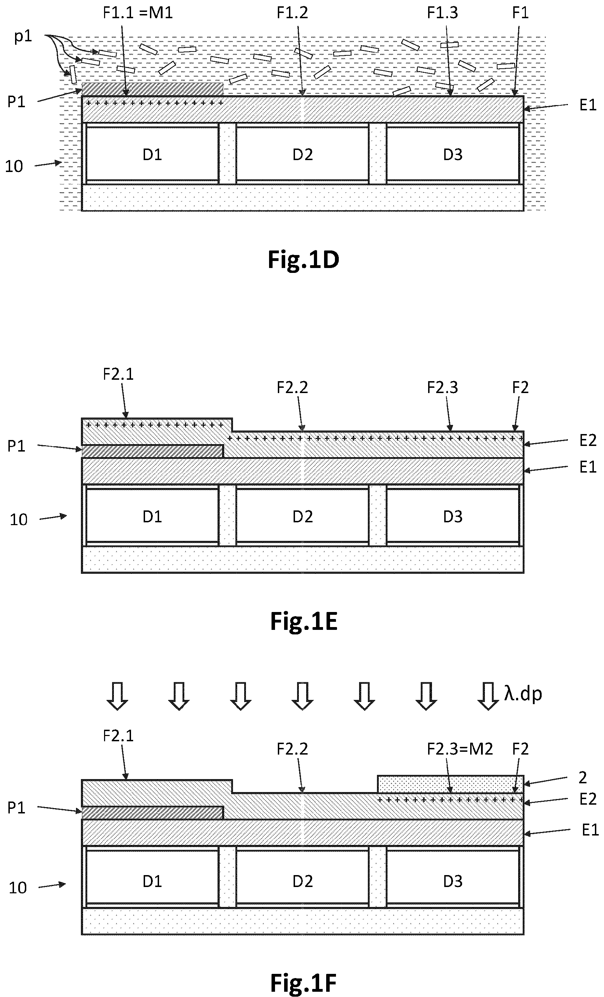

En référence à la fig.1D, on réalise ensuite les premiers plots photoluminescents P1, par dépôt localisé de premières particules photoluminescentes p1 sur la couche électret E1 en regard des premiers motifs de potentiel de surface M1. Pour cela, on opère d'une manière similaire à ce qui est décrit dans les documents WO2014/136023 et WO2021/023656. Ainsi, on met une solution colloïdale contenant les premières particules photoluminescentes p1 au contact de la face supérieure F1 de la couche électret E1. On peut ainsi plonger tout l'empilement dans la solution colloïdale, ou déposer une goutte d'une telle solution sur la couche électret E1. Du fait du potentiel de surface non nul situé dans les motifs de potentiel de surface M1, un champ électrique non uniforme est généré qui provoque un dépôt localisé des particules photoluminescentes p1 par diélectrophorèse. Aussi, les particules photoluminescentes p1 se déposent essentiellement en regard des premiers motifs M1, et sensiblement pas hors des motifs M1 (i.e. pas en regard des zones F1.2 et F1.3). Le temps de contact de la solution colloïdale sur la couche électret E1 dépend notamment de la quantité de particules photoluminescentes p1 à déposer, de la concentration en particules, de leur taille, du potentiel de surface, etc... A titre d'exemple, l'épaisseur des plots photoluminescents P1 peut être de l'ordre de quelques centaines de nanomètres, par exemple égale à 400nm environ. On retire ensuite la solution colloïdale et on peut sécher la couche électret E1. Notons que le potentiel de surface des motifs M1 est devenu sensiblement nul. En effet, les particules photoluminescentes p1 se greffent à la surface de la couche électret E1 au niveau des motifs M1, jusqu'à atténuation sensiblement complète du potentiel des motifs M1.

En référence aux fig.1E et 1F, on réalise ensuite une deuxième couche électret E2, qui recouvre au moins en partie la matrice de diodes 10, et dont la face supérieure F2 présente également des deuxièmes motifs de potentiel de surface M2 où le potentiel de surface est non nul. Les deuxièmes motifs de potentiel de surface M2 ne sont pas ici situés en regard des premiers plots photoluminescents P1, de sorte que les deuxièmes plots photoluminescents P2 soient en regard de diodes différentes des diodes D1, pour ainsi former des pixels lumineux d'une autre couleur.

Pour cela, en référence à la fig.1E, on dépose la deuxième couche électret E2, ici réalisée également en un matériau diélectrique auto-polarisé, de manière à recouvrir la première couche électret E1 ainsi que les premiers plots photoluminescents P1. Sa face supérieure F2 présente donc, sur toute sa surface, un potentiel de surface non nul. Cette deuxième couche électret E2 peut être réalisée en un matériau identique à celui de la première couche électret E1. Il est également choisi pour être au moins en partie absorbant à la longueur d'onde d'un rayonnement lumineux de dépolarisation (ici dans l'ultra-violet), et au moins en partie transparent à la longueur d'onde du rayonnement lumineux émis par les diodes (ici dans le bleu). La couche électret E2 peut présenter une épaisseur de l'ordre de quelques dizaines à centaines de nanomètres, et de préférence au plus égale à 2µm.

En référence à la fig.1F, on dépolarise localement la deuxième couche électret E2 par voie optique de manière à définir les deuxièmes motifs de potentiel de surface M2 définis dans sa face supérieure F2. Pour cela, on dépose une couche opaque sur la deuxième couche électret E2, que l'on structure ensuite par photolithographie et gravure pour obtenir un masque optique 2 qui ne s'étend ici qu'en regard des diodes D3. Il ne s'étend donc pas en regard des diodes D1 et D2. En variante, comme indiqué précédemment, le masque 2 peut être le masque de photolithographie au niveau du stepper.

Ensuite, on soumet la deuxième couche électret E2 au rayonnement lumineux de dépolarisation, qui est alors absorbé par la deuxième couche électret E2 uniquement dans les zones F2.1 et F2.2 (non recouvertes par le masque opaque 2), et non pas dans les zones F2.3. Aussi, l'absorption du rayonnement lumineux de dépolarisation provoque une dépolarisation localisée dans les zones F2.1 et F2.2 de la face supérieure F2 de la couche électret E2. Les zones F2.3de la face supérieure F2 de la couche électret E2 forment donc les deuxièmes motifs de potentiel de surface M2.

De préférence, si le potentiel des motifs M1 n'est pas totalement nul, une partie du rayonnement lumineux de dépolarisation est transmis par la deuxième couche électret E2, puis par les plots photoluminescents P1 pour être ensuite absorbé par la première couche électret E1, ce qui dépolarise localement les premiers motifs de potentiel de surface M1. On limite encore le risque que des deuxièmes particules photoluminescentes p2 ne viennent ensuite se déposer en regard des premiers plots photoluminescents P1.

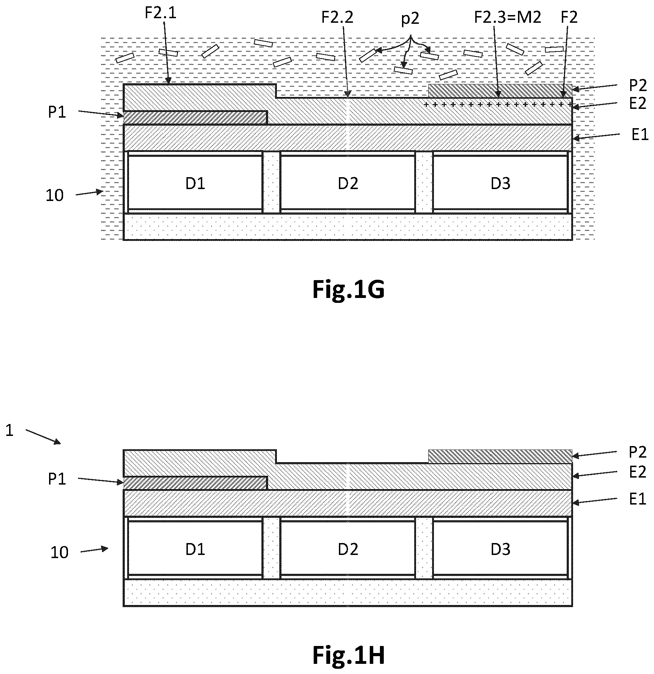

En référence à la fig.1G, on réalise ensuite les deuxièmes plots photoluminescents P2, par dépôt localisé de deuxièmes particules photoluminescentes p2 sur la couche électret E2 en regard des deuxièmes motifs de potentiel de surface M2. Pour cela, on opère comme pour les premiers plots photoluminescents P1, en mettant une solution colloïdale contenant les deuxièmes particules photoluminescentes p2 au contact de la face supérieure F2 de la deuxième couche électret E2. Du fait du potentiel de surface non nul situé dans les deuxièmes motifs M2, un champ électrique non uniforme est généré qui provoque un dépôt localisé des particules photoluminescentes p2 par diélectrophorèse. Aussi, les particules photoluminescentes p2 se déposent essentiellement en regard des deuxièmes motifs M2, et sensiblement pas hors des motifs M2 (i.e. non pas en regard des zones F2.1 et F2.2), et on obtient les deuxièmes plots photoluminescents P2. Notons que le potentiel de surface des motifs M2 devient sensiblement nul, à mesure que se greffent les particules photoluminescentes p2. On retire ensuite la solution colloïdale et on peut sécher la couche électret.

En référence à la fig.1H, on obtient ainsi un dispositif optoélectronique 1, qui comprend une matrice de diodes 10 et une structure de conversion de couleur formée de plots photoluminescents P1 et P2. Dans cet exemple, les diodes D2 forment des pixels bleus, les diodes D1 associées aux plots photoluminescents P1 forment par exemple des pixels rouges, et les diodes D3 associés aux plots photoluminescents P2 forment des pixels verts. Pour former les plots photoluminescents, le procédé a mis en œuvre une étape de dépolarisation localisée, par voie optique, de couches électrets E1 et E2 présentant un potentiel de surface initialement non nul sur toute la surface de la face supérieure. On évite donc d'avoir recours à une étape d'injection localisée de charges électriques dans une couche électret initialement sans charges électriques, comme dans les exemples de l'art antérieur mentionné précédemment. Aussi, le procédé est rapide et la réalisation des plots photoluminescents est spatialement précise, même dans le cadre d'une matrice de diodes réalisées à partir de substrat de grande dimension (par exemple 100 ou 200 mm) et/ou dont le pas pixel est très petit (par exemple 5 µm ou moins).

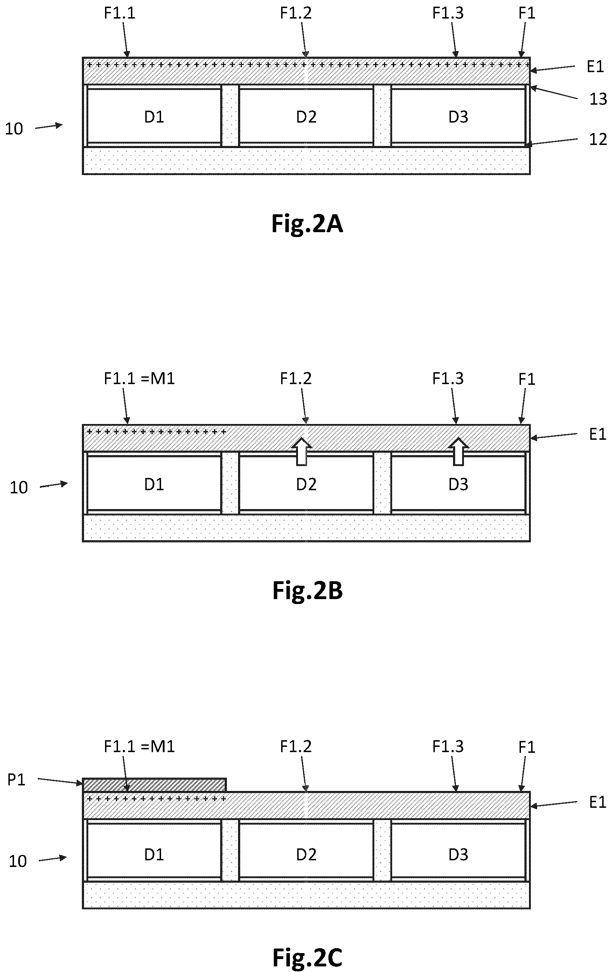

Les figures 2A à 2C illustrent différentes étapes d'un procédé de fabrication d'un dispositif optoélectronique selon une variante de réalisation. Dans cet exemple, les motifs de potentiel de surface sont réalisés par dépolarisation localisée, par voie optique, d'une couche électret présentant initialement, sur toute sa surface, un potentiel de surface non nul.

Ce procédé se distingue de celui des figures 1A-1H essentiellement en ce que le rayonnement lumineux de dépolarisation correspond au rayonnement lumineux émis par les diodes. Dans ce cas, la matrice de diodes est adaptée à activer sélectivement les diodes D1, D2 et D3, et comporte pour cela des électrodes inférieures 12 et supérieures 13 agencées pour permettre cette activation sélective.

De plus, le matériau de la couche électret E1 est adapté à absorber en partie seulement le rayonnement lumineux émis par les diodes D1, D2, D3, et à transmettre la partie non absorbée. Ainsi, la partie absorbée permet de dépolariser localement la couche électret, dans les zones de la face supérieure en regard des diodes activées. Les zones de la face supérieure situées en regard des diodes non activées gardent alors leur potentiel de surface non nul, et définissent alors les motifs de potentiel de surface.

En référence à la fig.2A, on fournit une matrice de diodes 10 recouverte par une couche électret E1. La face supérieure F1 de celle-ci présente, sur toute sa surface, un potentiel de surface non nul. La couche électret E1 est alors réalisée en un matériau diélectrique adapté à absorber en partie seulement le rayonnement lumineux émis par les diodes, ici dans le bleu (ou proche bleu).

En référence à la fig.2B, on active les diodes de manière sélective, c'est-à-dire que seule une partie d'entre elles est activée. Ici, on active les diodes D2 et D3 seulement, et non pas les diodes D1. Le rayonnement lumineux émis est alors en partie absorbé localement par la couche électret E1 dans les zones F1.2 et F1.3 de la face supérieure F1 situées en regard des diodes D2 et D3, ce qui se traduit par une dépolarisation locale de la couche électret E1 en regard de ces diodes. En revanche, dans la mesure où les diodes D1 ne sont pas activées, la couche électret E1 reste localement polarisée dans les zones F1.1, lesquelles définissent alors les premiers motifs de potentiel de surface M1.

En référence à la fig.2C, on réalise ensuite les premiers plots photoluminescents P1, de la même manière que précédemment (cf. fig.1D), par mise en contact de la couche électret E1 avec une solution colloïdale contenant les particules photoluminescentes p1. Celles-ci se déposent alors naturellement sur la couche électret E1 dans les motifs de potentiel de surface M1, de sorte que les plots photoluminescents P1 sont positionnés en regard des diodes D1 et non pas en regard des diodes D2 et D3.

Le procédé de fabrication peut être poursuivi de la même manière que précédemment (non représenté). Ainsi, on dépose une deuxième couche électret E2, qui recouvre ici la matrice de diodes 10 ainsi que les premiers plots P1 et la couche électret E1. La face supérieure de la couche électret E2 présente un potentiel de surface non nul sur toute sa surface. On dépolarise ensuite localement cette deuxième couche électret E2 par voie optique, de manière identique à la fig.2B. Ainsi, on active les diodes D1 et D2 seulement, de manière à dépolariser les zones F2.1 et F2.2 de la face supérieure F2 de la couche électret E2. En revanche, on n'active pas les diodes D3, de sorte que les zones F2.3 présentent un potentiel de surface non nul, et forment ainsi les deuxièmes motifs de potentiel de surface M2. Notons que, en variante, la dépolarisation localisée par voie optique de la deuxième couche électret E2 peut être effectuée comme dans le procédé des figures 1A-1H, c'est-à-dire en utilisant un rayonnement lumineux de dépolarisation dédié, distinct de celui émis par les diodes.

Ainsi, dans cette variante de réalisation, le procédé de fabrication met à profit l'activation sélective des diodes de la matrice 10 pour dépolariser localement la ou les couches électrets E1, E2, et ainsi définir les motifs de potentiel de surface. Cela permet notamment de simplifier le procédé de réalisation, et notamment les étapes de dépolarisation.

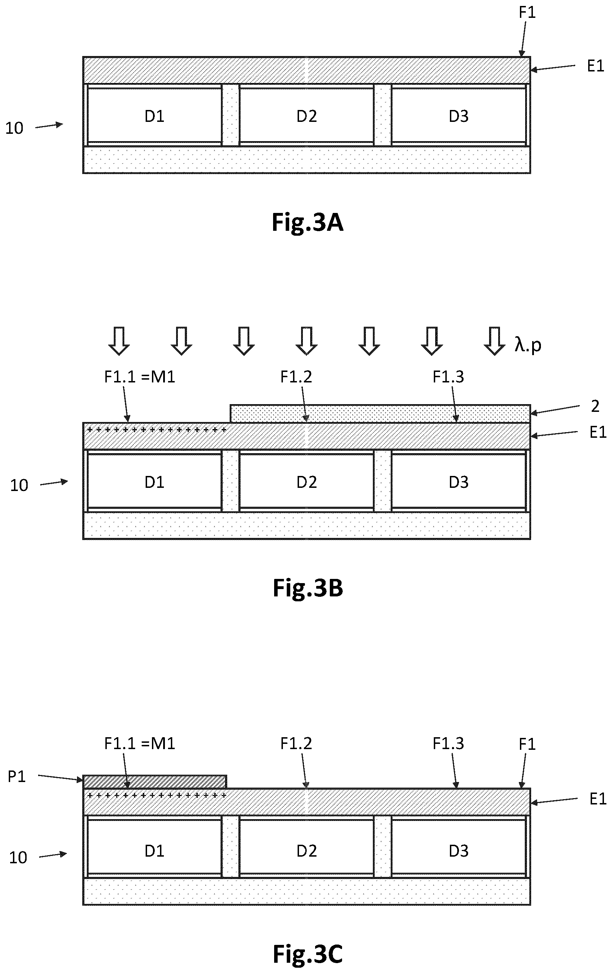

Les figures 3A à 3C illustrent différentes étapes d'un procédé de fabrication d'un dispositif optoélectronique selon une autre variante de réalisation.

Ce procédé se distingue de celui des figures 1A-1H essentiellement en ce que la couche électret E1 est réalisée à partir d'un matériau diélectrique photochromique qui est polarisé localement par voie optique pour former les motifs de potentiel de surface, et non pas par dépolarisation d'une couche électret présentant un potentiel de surface initialement non nul. Autrement dit, les motifs de potentiel de surface sont réalisés par polarisation localisée, par voie optique, d'une couche électret présentant initialement un potentiel de surface nul sur toute sa surface.

Le matériau photochromique de la couche électret E1 est alors adapté à absorber au moins en partie un rayonnement lumineux de polarisation prédéfini, par exemple entre 100nm et 380nm, conduisant à une polarisation électrique de la couche. Enfin, il est également au moins en partie transparent au rayonnement lumineux émis par les diodes, par exemple dans le bleu. Le matériau photochromique peut être un composé d'un matériau matrice tel que Poly(méthyl-méthacrylate) (PMMA) ou polystyrène (PS), contenant de 1 à 20% massique d'un matériau photochromique qui peut être choisi parmi de Spiropyrans (SP) ou 1',3'-dihydrol, 3',3'trimethyl-6-nitrospiro[2H-1-benzopyran-2,2 112 0-(2H)-indole] ou N,N'-ditridecylperylene-3,4,9,10-tetracarboxylic diimide (PTCDI-C13H27) ou 1,2-bis-[2-methyl-5-(p-cyanophenyl)-3-thienyl]perfluorocyclopentene (DTE-CN). Ce dernier matériau est notamment présenté dans l'article de Castagna et al. intitulé Photochromic Electret: A New Tool for Light Energy Harvesting, The Journal of Physical Chemistry Letters, 3(1), 51-57, 2012.

En référence à la fig.3A, on fournit une matrice de diodes 10 recouverte par une couche électret E1. La face supérieure F1 de celle-ci présente, sur toute sa surface, un potentiel de surface sensiblement nul. La couche électret E1 est alors réalisée en un matériau photochromique.

En référence à la fig.3B, on forme ensuite les motifs de potentiel de surface M1, par une polarisation localisée de la couche électret E1 par voie optique. On soumet ici à travers un masque opaque 2 (un masque déposé sur la couche électret, le masque de photolithographie...) en regard des diodes D2 et D3, ici sur la zone F1.2 et F1.3 de la face supérieure F1 à un rayonnement lumineux de polarisation, de longueur d'onde λ.p prédéfinie, qui n'est absorbé par la couche électret E1 que dans la zone F1.1, et non pas dans les zones F1.2 et F1.3. Ainsi, le potentiel de surface n'est pas défini dans les zones F1.2 et F1.3 et reste nul, alors qu'il est non nul dans la zone F1.1, ce qui définit les motifs de potentiel de surface M1.

A noter que la polarisation localisée de la couche électret E1 peut évidemment être effectuée par l'activation sélective des diodes de la matrice 10.

En référence à la fig.3C, on réalise ensuite les premiers plots photoluminescents P1, de la même manière que précédemment (cf. fig.2C), par mise en contact de la couche électret E1 avec une solution colloïdale contenant les particules photoluminescentes p1. Celles-ci se déposent alors naturellement sur la couche électret E1 dans les motifs de potentiel de surface M1, de sorte que les plots photoluminescents P1 sont positionnés en regard des diodes D1 et non pas en regard des diodes D2 et D3.

Le procédé de fabrication peut être poursuivi de la même manière que précédemment (non représenté), à ceci près qu'il n'est pas nécessaire d'utiliser une deuxième couche électret E2. Ainsi, on réalise une deuxième insolation de la couche électret E1 qui présente des motifs de potentiel de surface M2 (situés en regard par exemple des diodes D3), et enfin on réalise les plots photoluminescents P2 situés en regard des motifs de potentiel de surface M2. Une fois que tous les plots photoluminescents sont déposés par diélectrophorèse, une insolation en lumière visible de l'ensemble de la couche électret E1 est avantageusement effectuée afin d'améliorer, si besoin, la transparence de cette couche dans la gamme visible du spectre.

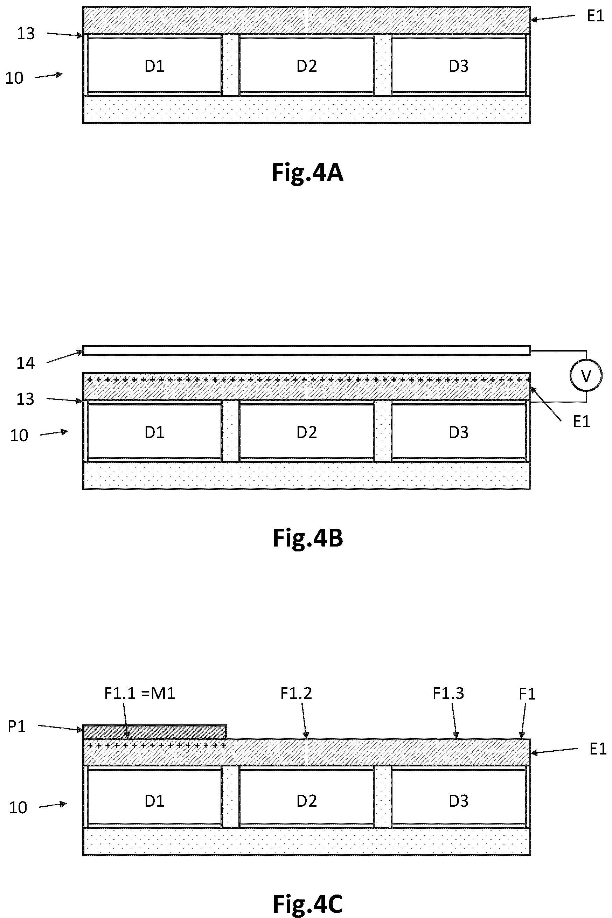

Les figures 4A à 4F illustrent différentes étapes d'un procédé de fabrication d'un dispositif optoélectronique selon une autre variante de réalisation.

Ce procédé se distingue du procédé décrit sur les figures 1A et suivantes essentiellement en ce qu'au moins l'une des couches électrets, et ici les deux couches électrets E1, E2, est réalisée en un matériau diélectrique qui est polarisé électriquement par voie électrostatique. Pour cela, on met à profit la couche électrode supérieure 13. Autrement dit, les motifs de potentiel de surface sont réalisés par dépolarisation localisée, par voie optique, d'une couche électret présentant initialement, sur toute sa surface, un potentiel de surface non nul.

En référence à la fig.4A, on fournit une matrice de diodes 10 recouverte par une couche électret E1. La face supérieure F1 de celle-ci présente, sur toute sa surface, un potentiel de surface initial sensiblement nul. La couche électret E1 est alors réalisée en un matériau diélectrique inorganique tel que, par exemple, un oxyde de silicium (SiₓO_{y}), un nitrure de silicium (SiₓN_{y}), un oxyde d'aluminium (AlₓO_{y}), un oxyde de titane (TiₓO_{y}), un oxyde de tantale (TaₓO_{y}), un oxyde d'halfnium (HfₓO_{y}), voire même un matériau diélectrique organique (PMMA...).

En référence à la fig.4B, on définit un potentiel de surface non nul sur toute la surface de la face supérieure de la couche électret E1. Pour cela, on tire profit de la couche électrode supérieure 13 qui s'étend sous toute la surface de la couche électret E1. On approche également une électrode supplémentaire 14 disposée au-dessus de toute la couche électret E1, et on applique une différence de potentiel entre ces deux électrodes 13, 14. Un potentiel de surface non nul est alors créé sur toute la surface de la face supérieure de la couche électret E1. D'autres techniques de chargement de la couche électret sont envisageables (plasma, implémentation ionique, décharge corona...).

En référence à la fig.4C, on définit ensuite les motifs de potentiel de surface M1, par dépolarisation localisée de la couche électret E1 par voie optique, selon l'une de manières décrites précédemment. Puis on réalise ensuite les premiers plots photoluminescents P1, de la même manière que précédemment (cf. fig.1D), par mise en contact de la couche électret E1 avec une solution colloïdale contenant les particules photoluminescentes p1. Celles-ci se déposent alors naturellement sur la couche électret E1 dans les motifs de potentiel de surface M1, de sorte que les plots photoluminescents P1 sont positionnés en regard des diodes D1 et non pas en regard des diodes D2 et D3. Le potentiel de surface des motifs M1 devient alors sensiblement nul.

On réalise ensuite une deuxième couche électret E2 présentant des motifs de potentiel de surface M2. Ici, la couche électret E2 est réalisée comme la couche électret E1 par polarisation par voie électrostatique d'une couche présentant un potentiel électrique initial nul. En variante, la deuxième couche électret peut être réalisée comme dans les exemples décrits précédemment en référence aux fig.1A-1H, aux fig.2A-2C et aux fig.3A-3C.

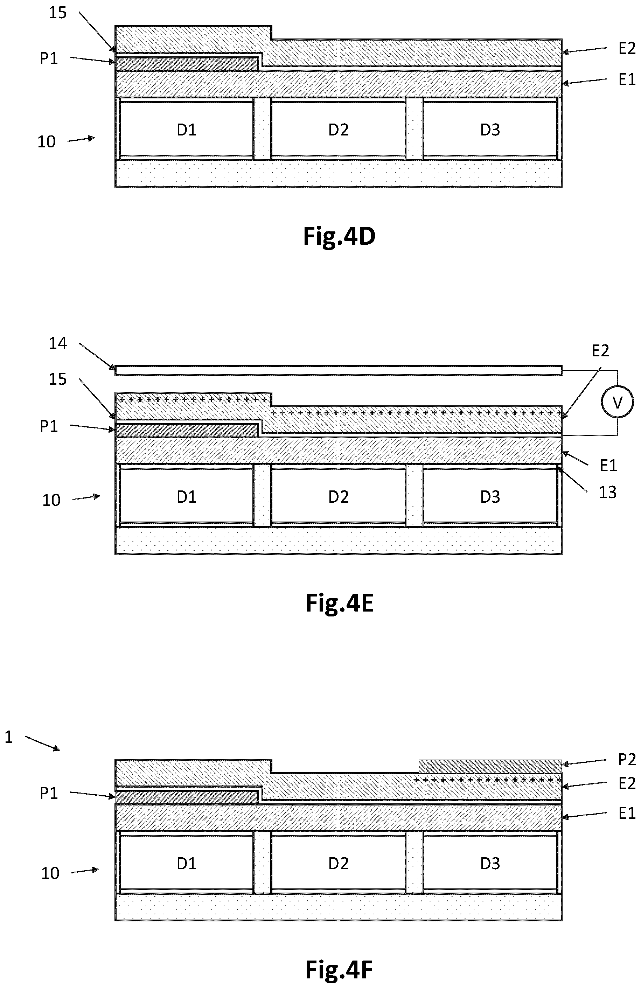

En référence à la fig.4D, on réalise tout d'abord une couche électrode 15 qui recouvre toute la matrice de diodes 10, et ici plus précisément les plots photoluminescents P1 et la couche électret E1. Puis on dépose une couche électret E2. Elle s'étend entièrement sur la couche électrode 15 et assure ici également l'encapsulation des particules photoluminescentes du plot P1. La face supérieure de la couche électret E2 présente, sur toute sa surface, un potentiel de surface initial sensiblement nul. La couche électret E2 peut être réalisée en un matériau diélectrique identique à celui de la couche électret E1.

En référence à la fig.4E, on définit un potentiel de surface non nul sur toute la surface de la face supérieure de la couche électret E2. Pour cela, on applique une différence de potentiel entre la couche électrode 15 et une électrode supplémentaire 14 disposée au-dessus de toute la couche électret E2. Un potentiel de surface non nul est alors créé sur toute la surface de la face supérieure de la couche électret E2. Notons que la couche électrode 15 pourrait ne pas être utilisée : on appliquerait alors une différence de potentiel entre l'électrode 14 et l'électrode 13.

En référence à la fig.4F, on définit ensuite les motifs de potentiel de surface M2, par dépolarisation localisée de la couche électret E2 par voie optique. Puis on réalise ensuite les plots photoluminescents P2, de la même manière que précédemment (cf. fig.1G), par mise en contact de la couche électret E2 avec une solution colloïdale contenant les particules photoluminescentes p2. Celles-ci se déposent alors naturellement sur la couche électret E2 dans les motifs de potentiel de surface M2, de sorte que les plots photoluminescents P2 sont positionnés en regard des diodes D2 et non pas en regard des diodes D1 et D2. Le potentiel de surface des motifs M2 devient alors sensiblement nul.

Des modes de réalisation particuliers viennent d'être décrits. Différentes variantes et modifications apparaîtront à l'homme du métier. La portée de l'invention est définie par les revendications.

## Revendications

1. Procédé de fabrication d'un dispositif optoélectronique (1) comportant :
• une matrice de diodes (10), adaptées à émettre ou recevoir un rayonnement lumineux ; et
• une structure de conversion de couleur, recouvrant au moins en partie la matrice de diodes (10), et contenant des plots photoluminescents (P1) disposés chacun en regard d'au moins une diode ;
∘ le procédé comportant les étapes suivantes :
∘ A/ fournir la matrice de diodes (10) ;
∘ B/ réaliser une couche électret (E1), recouvrant la matrice de diodes (10), et dont une face supérieure (F1), opposée à la matrice de diodes (10), présente des motifs de potentiel de surface (M1) prédéfinis où le potentiel de surface est non nul ;
∘ C/ réaliser les plots photoluminescents (P1), par mise en contact de la couche électret (E1) avec une solution colloïdale contenant des particules photoluminescentes (p1), lesquelles se déposent alors sur la face supérieure (F1) de la couche électret (E1) en regard des motifs de potentiel de surface (M1) prédéfinis, formant ainsi les plots photoluminescents (P1) ;
∘ et dans lequel l'étape B de réalisation de la couche électret (E1) comporte les étapes suivantes :
• B1/ réaliser une couche électret (E1) dont la face supérieure (F1) présente, sur toute sa surface, un potentiel de surface initial non nul ou nul ; puis
• B2a/ dans le cas où le potentiel de surface initial est non nul : éclairer des zones de la couche électret (E1) par un rayonnement lumineux dit de dépolarisation apte à être absorbé au moins en partie par la couche électret (E1), lesdites zones éclairées étant distinctes de zones non éclairées destinées à former les motifs de potentiel de surface (M1), l'absorption du rayonnement lumineux de dépolarisation dans les zones éclairées provoquant une annulation du potentiel de surface local, les zones non éclairées définissant alors les motifs de potentiel de surface (M1) ;
• B2b/ ou, dans le cas où le potentiel de surface initial est nul : éclairer des zones de la couche électret (E1) par un rayonnement lumineux dit de polarisation apte à être absorbé au moins en partie par la couche électret (E1), l'absorption du rayonnement lumineux de polarisation dans les zones éclairées provoquant une formation d'un potentiel de surface local non nul, les zones éclairées définissant alors les motifs de potentiel de surface (M1).

2. Procédé de fabrication selon la revendication 1, comportant, au préalable de l'étape B2a ou B2b, une étape de disposition d'un masque opaque (2), en un matériau opaque au rayonnement lumineux de dépolarisation ou de polarisation, s'étendant uniquement sur les zones de la couche électret (E1) destinées à former les motifs de potentiel de surface (M1) ; puis, lors de l'étape B2a ou B2b, le rayonnement lumineux de dépolarisation ou de polarisation est émis en direction du masque opaque (2) et de la couche électret (E1), et est absorbé par la couche électret (E1) dans les zones non recouvertes par le masque opaque (2).

3. Procédé de fabrication selon la revendication 1, dans lequel :
o les diodes sont des diodes électroluminescentes ;
o la couche électret (E1) est réalisée en un matériau adapté à absorber partiellement le rayonnement lumineux émis par les diodes électroluminescentes, ce qui provoque une annulation du potentiel de surface local ;
o lors de l'étape B2a, des diodes sont activées sélectivement de manière à éclairer la couche électret dans les zones destinées à ne pas former les motifs de potentiel de surface (M1), ce qui provoque une annulation du potentiel de surface local, les zones non éclairées définissant alors les motifs de potentiel de surface (M1) ;
o ou, lors de l'étape B2b, des diodes sont activées sélectivement de manière à éclairer la couche électret uniquement dans les zones destinées à former les motifs de potentiel de surface (M1).

4. Procédé de fabrication selon l'une quelconque des revendications 1 à 3 en lien avec l'étape B2a, dans lequel la couche électret (E1) est réalisée en un matériau diélectrique organique auto-polarisé, de sorte que l'étape B1 consiste à déposer la couche électret (E1) recouvrant la matrice de diodes (10), la couche électret (E1) présentant alors, sur toute sa surface, un potentiel de surface initial non nul.

5. Procédé de fabrication selon l'une quelconque des revendications 1 à 3 en lien avec l'étape B2b, dans lequel la couche électret (E1) est réalisée en un matériau diélectrique photochromique, de sorte que l'étape B1 consiste à déposer une couche électret (E1), en le matériau diélectrique photochromique, recouvrant la matrice de diodes (10), la couche électret (E1) présentant alors, sur toute sa surface, un potentiel de surface nul.

6. Procédé de fabrication selon l'une quelconque des revendications 1 à 3 en lien avec l'étape B2a, dans lequel la couche électret (E1) est réalisée en un matériau diélectrique, de sorte que l'étape B1 comporte les étapes suivantes :
o déposer une couche électret (E1), en le matériau diélectrique, recouvrant la matrice de diodes (10), la couche électret (E1) présentant alors, sur toute sa surface, un potentiel de surface initial nul ; puis
o soumettre la couche électret (E1) à un champ électrique dit de polarisation prédéfini, provoquant une formation d'un potentiel de surface non nul sur toute la surface de la couche électret (E1).

7. Procédé de fabrication selon la revendication précédente, dans lequel :
o la matrice de diodes (10) comporte une couche électrode supérieure (13) recouvrant les diodes et adaptée à polariser électriquement les diodes,
o lors de l'étape de soumission de la couche électret (E1) au champ électrique de polarisation, la couche électret (E1) est disposée alors entre la couche électrode supérieure (13) et une électrode (14) rapportée, entre lesquelles est appliquée une différence de potentiel prédéfinie.

8. Procédé de fabrication selon l'une quelconque des revendications 1 à 7, dans lequel :
o la couche électret (E1) réalisée lors de l'étape B est une première couche électret ; et les plots photoluminescents (P1) réalisés lors de l'étape C sont des premiers plots photoluminescents adaptés à convertir un rayonnement lumineux incident d'une première longueur d'onde en un rayonnement lumineux d'une deuxième longueur d'onde différente de la première longueur d'onde ;
o le procédé comportant les étapes suivantes, à la suite de l'étape C :
o D/ réaliser une deuxième couche électret (E2), recouvrant la matrice de diodes (10) et la première couche électret (E1), et dont une face supérieure (F1), opposée à la matrice de diodes (10), présente des deuxièmes motifs de potentiel de surface (M2) prédéfinis où le potentiel de surface est non nul, lesdits deuxièmes motifs de potentiel de surface (M2) étant situés en regard de diodes distinctes de celles en regard desquelles sont situés les premiers motifs de potentiel de surface (M1) ;
o E/ réaliser les deuxièmes plots photoluminescents (P2), par mise en contact de la deuxième couche électret (E2) avec une solution colloïdale contenant des deuxièmes particules photoluminescentes (p2), différentes des premières particules photoluminescentes (p1) de l'étape C, qui se déposent alors sur la face supérieure (F2) de la deuxième couche électret (E2) en regard des deuxièmes motifs de potentiel de surface (M2) prédéfinis, formant ainsi les deuxièmes plots photoluminescents (P2).

9. Procédé de fabrication selon la revendication précédente, dans lequel les diodes de la matrice (10) sont des diodes électroluminescentes adaptées à émettre un rayonnement lumineux à une même longueur d'onde ; et forment avec les premiers et deuxièmes plots photoluminescents (P1, P2) une matrice de pixels lumineux rouges, verts, bleus.

10. Procédé de fabrication selon l'une quelconque des revendications 1 à 9, dans lequel la matrice de diodes (10) présente une dimension, dans un plan parallèle à la matrice de diodes (10), supérieure ou égale à 100mm.

11. Procédé de fabrication selon l'une quelconque des revendications 1 à 10, dans lequel la matrice de diodes (10) présente un pas de périodicité inférieure ou égale à 10µm, voire à 5µm, voire à 2µm.

## Patentansprüche

1. Verfahren zur Fertigung einer optoelektronischen Vorrichtung (1), die Folgendes aufweist:
• eine Diodenmatrix (10), die geeignet ist, eine Lichtstrahlung zu senden und empfangen; und
• eine Farbumwandlungsstruktur, die mindestens teilweise die Diodenmatrix (10) bedeckt und jeweils gegenüber mindestens einer Diode angeordnete photolumineszierende Stellen (P1) enthält;
∘ wobei das Verfahren ferner die folgenden Schritte aufweist:
∘ A/ Bereitstellen der Diodenmatrix (10);
∘ B/ Herstellen einer Elektretschicht (E1), die die Diodenmatrix (10) bedeckt, und deren Oberseite (F1), gegenüber der Diodenmatrix (10), vordefinierte Oberflächenpotenzialmuster (M1) beinhaltet, bei denen das Oberflächenpotenzial nicht null ist;
∘ C/ Herstellen der photolumineszierenden Stellen (P1) durch Inkontaktbringen der Elektretschicht (E1) mit einer kolloidalen Lösung, die photolumineszierende Partikel (p1) enthält, die sich dann auf der Oberseite (F1) der Elektretschicht (E1) gegenüber den vordefinierten Oberflächenpotenzialmustern (M1) absetzen und so die photolumineszierenden Stellen (P1) bilden;
∘ und wobei der Schritt B zum Herstellen der Elektretschicht (E1) die folgenden Schritte aufweist:
• B1/ Herstellen einer Elektretschicht (E1), deren Oberseite (F1) auf ihrer gesamten Oberfläche ein anfängliches Oberflächenpotenzial von nicht null oder null beinhaltet; dann
• B2a/ falls das anfängliche Oberflächenpotenzial nicht null ist: Bestrahlen von Bereichen der Elektretschicht (E1) mit einer Depolarisationslichtstrahlung, die mindestens teilweise von der Elektretschicht (E1) absorbiert werden kann, wobei die bestrahlten Bereiche sich von nicht bestrahlten Bereichen unterscheiden, die dazu bestimmt sind, die Oberflächenpotenzialmuster (M1) zu bilden, wobei die Absorption der Depolarisationslichtstrahlung in den bestrahlten Bereichen eine Aufhebung des lokalen Oberflächenpotenzials verursacht, wobei die nicht bestrahlten Bereiche dann die Oberflächenpotenzialmuster (M1) definieren;
• B2b/ oder, falls das anfängliche Oberflächenpotenzial null ist: Bestrahlen von Bereichen der Elektretschicht (E1) mit einer Polarisationslichtstrahlung, die mindestens teilweise von der Elektretschicht (E1) absorbiert werden kann, wobei die Absorption der Polarisationslichtstrahlung in den bestrahlten Bereichen die Bildung eines lokalen Oberflächenpotenzials verursacht, das nicht null ist, wobei die bestrahlten Bereiche dann die Oberflächenpotenzialmuster (M1) definieren.

2. Fertigungsverfahren nach Anspruch 1, das vor dem Schritt B2a oder B2b einen Schritt der Anordnung einer undurchsichtigen Maske (2) aus einem Material aufweist, das undurchsichtig gegenüber der Depolarisations- oder Polarisationslichtstrahlung ist und sich nur auf die Bereiche der Elektretschicht (E1) erstreckt, die dazu bestimmt sind, das Oberflächenpotenzialmuster (M1) zu bilden; dann wird in Schritt B2a oder B2b die Depolarisations- oder Polarisationslichtstrahlung in Richtung der undurchsichtigen Maske (2) und der Elektretschicht (E1) emittiert und von der Elektretschicht (E1) in den Bereichen absorbiert, die nicht von der undurchsichtigen Maske (2) abgedeckt sind.

3. Fertigungsverfahren nach Anspruch 1, wobei:
∘ die Dioden Leuchtdioden sind;
∘ die Elektretschicht (E1) aus einem Material hergestellt ist, das geeignet ist, die von den Leuchtdioden ausgestrahlte Lichtstrahlung teilweise zu absorbieren, was zu einer Aufhebung des lokalen Oberflächenpotenzials führt;
∘ in Schritt B2a Dioden selektiv aktiviert werden, um die Elektretschicht in den Bereichen zu bestrahlen, die nicht dazu bestimmt sind, die Oberflächenpotenzialmuster (M1) zu bilden, was zu einer Aufhebung des lokalen Oberflächenpotenzials führt, wobei die nicht bestrahlten Bereiche dann die Oberflächenpotenzialmuster (M1) definieren;
∘ oder in Schritt B2b Dioden selektiv so aktiviert werden, dass die Elektretschicht nur in den Bereichen bestrahlt wird, die dazu bestimmt sind, das Oberflächenpotenzialmuster (M1) zu bilden.

4. Fertigungsverfahren nach einem der Ansprüch 1 bis 3 in Verbindung mit Schritt B2a, wobei die Elektretschicht (E1) aus einem selbstpolarisierenden organischen Dielektrizitätsmaterial hergestellt ist, so dass der Schritt B1 darin besteht, die die Diodenmatrix (10) bedeckende Elektretschicht (E1) abzusetzen, wobei die Elektretschicht (E1) dann über ihre gesamte Oberfläche ein anfängliches Oberflächenpotenzial von nicht null beinhaltet.

5. Fertigungsverfahren nach einem der Ansprüch 1 bis 3 in Verbindung mit Schritt B2b, wobei die Elektretschicht (E1) aus einem photochromen dielektrischen Material hergestellt ist, so dass der Schritt B1 darin besteht, eine Elektretschicht (E1) aus dem photochromen dielektrischen Material, die die Diodenmatrix (10) bedeckt, absetzt, wobei die Elektretschicht (E1) dann über ihre gesamte Oberfläche kein Oberflächenpotenzial beinhaltet.

6. Fertigungsverfahren nach einem der Ansprüch 1 bis 3 in Verbindung mit Schritt B2a, wobei die Elektretschicht (E1) aus einem dielektrischen Material hergestellt ist, so dass Schritt B1 folgende Schritte aufweist:
∘ Absetzen einer Elektretschicht (E1) aus dem dielektrischen Material, die die Diodenmatrix (10) bedeckt, wobei die Elektretschicht (E1) dann über ihre gesamte Oberfläche ein anfängliches Oberflächenpotenzial von null beinhaltet; dann
∘ Aussetzen der Elektretschicht (E1) einem vordefinierten Polarisationsfeld, wodurch sich über die gesamte Oberfläche der Elektretschicht (E1) ein Oberflächenpotenzial von nicht null bildet.

7. Fertigungsverfahren nach dem vorhergehenden Anspruch, wobei:
∘ die Diodenmatrix (10) eine obere Elektrodenschicht (13) aufweist, die die Dioden bedeckt und geeignet ist, die Dioden elektrisch zu polarisieren,
∘ bei dem Schritt des Aussetzens der Elektretschicht (E1) dem elektrischen Polarisationsfeld dann die Elektretschicht (E1) zwischen der oberen Elektrodenschicht (13) und einer aufgetragenen Elektrode (14) angeordnet wird, zwischen denen eine vordefinierte Potenzialdifferenz angelegt wird.

8. Fertigungsverfahren nach einem der Ansprüche 1 bis 7, wobei:
∘ die in Schritt B hergestellte Elektretschicht (E1) eine erste Elektretschicht ist; und die in Schritt C hergestellten photolumineszierenden Stellen (P1) erste photolumineszierende Stellen sind, die geeignet sind, eine einfallende Lichtstrahlung einer ersten Wellenlänge in eine Lichtstrahlung einer zweiten Wellenlänge umzuwandeln, die sich von der ersten Wellenlänge unterscheidet;
∘ wobei das Verfahren nach Schritt C folgende Schritte aufweist:
∘ D/ Herstellen einer zweiten Elektretschicht (E2), die die Diodenmatrix (10) und die erste Elektretschicht (E1) bedeckt und deren Oberseite (F1), gegenüber der Diodenmatrix (10), vordefinierte zweite Oberflächenpotenzialmuster (M2) beinhaltet, bei denen das Oberflächenpotenzial nicht null ist, wobei die zweiten Oberflächenpotenzialmuster (M2) gegenüber Dioden liegen, die sich von denen unterscheiden, gegenüber denen sich die ersten Oberflächenpotenzialmuster (M1) befinden;
∘ E/ Herstellen der zweiten photolumineszierenden Stellen (P2) durch Inkontaktbringen der zweiten Elektretschicht (E2) mit einer kolloidalen Lösung, die zweite photolumineszierende Partikel (p2) enthält, die sich von den ersten photolumineszierenden Partikeln (p1) des Schritts C unterscheiden und sich dann auf der Oberseite (F2) der zweiten Elektretschicht (E2) gegenüber den zweiten vordefinierten Oberflächenpotenzialmustern (M2) absetzen und so die zweiten photolumineszierenden Stellen (P2) bilden.

9. Fertigungsverfahren nach dem vorhergehenden Anspruch, wobei die Dioden der Matrix (10) Leuchtdioden sind, die geeignet sind, eine Lichtstrahlung bei gleicher Wellenlänge auszusenden; und zusammen mit den ersten und zweiten photolumineszierenden Stellen (P1, P2) eine Matrix aus roten, grünen, blauen Lichtpixeln bilden.

10. Fertigungsverfahren nach einem der Ansprüche 1 bis 9, wobei die Diodenmatrix (10) in einer Ebene parallel zu der Diodenmatrix (10) eine Abmessung größer oder gleich 100 mm beinhaltet.

11. Fertigungsverfahren nach einem der Ansprüche 1 bis 10, wobei die Diodenmatrix (10) einen Periodizitätsabstand kleiner oder gleich 10 µm oder sogar 5 µm oder sogar 2 µm beinhaltet.

## Claims

1. A method for manufacturing an optoelectronic device (1) including:
• an array of diodes (10), configurated to emit or receive a light radiation; and
• a colour conversion structure, covering at least partially the array of diodes (10), and containing photoluminescent pads (P1) arranged opposite at least one diode;
o the method including the following steps:
∘ A/ providing the array of diodes (10);
∘ B/ making an electret layer (E1), covering the array of diodes (10), and an upper face of which (F1), opposite to the array of diodes (10), has predefined surface potential patterns (M1) where the surface potential is non-zero;
∘ C/ making the photoluminescent pads (P1), by contact of the electret layer (E1) with a colloidal solution containing photoluminescent particles (p1), which are then deposited over the upper face (F1) of the electret layer (E1) opposite the predefined surface potential patterns (M1), thereby forming the photoluminescent pads (P1);
∘ and wherein step B of making the electret layer (E1) includes the following steps:
• B1/ making an electret layer (E1) whose upper face (F1) has, over its entire face, a non-zero or zero initial surface potential; then
• B2a/ in the case where the initial surface potential is non-zero: illuminate areas of the electret layer (E1) with a depolarisation light radiation which can be absorbed at least partially by the electret layer (E1), said illuminated areas being distinct from non-illuminated areas intended to form the surface potential patterns (M1), the absorption of the depolarisation light radiation in the illuminated areas causing a cancellation of the local surface potential, the non-illuminated areas then defining the surface potential patterns (M1);
• B2b/ or, in the case where the initial surface potential is zero: illuminate areas of the electret layer (E1) by a polarisation light radiation which can be absorbed at least partially by the electret layer (E1), the absorption of the polarisation light radiation in the illuminated areas causing a formation of a non-zero local surface potential, the illuminated areas then defining the surface potential patterns (M1).

2. The manufacturing method according to claim 1, including, prior to step B2a or B2b, a step of arranging an opaque mask (2), made of a material opaque to the depolarisation or polarisation light radiation, extending only over the areas of the electret layer (E1) intended to form the surface potential patterns (M1); then, during step B2a or B2b, the depolarisation or polarisation light radiation is emitted in the direction of the opaque mask (2) and the electet layer (E1), and is absorbed by the electret layer (E1) in the areas not covered by the opaque mask (2).

3. The manufacturing method according to claim 1, wherein:
o the diodes are light-emitting diodes;
o the electret layer (E1) is made of a material configured to partially absorb the light radiation emitted by the light-emitting diodes, which causes a cancellation of the local surface potential;
o during step B2a, some diodes are selectively activated so as to illuminate the electret layer in the areas intended not to form the surface potential patterns (M1), which causes a cancellation of the local surface potential, the non-illuminated areas then defining the surface potential patterns (M1);
o or, during step B2b, diodes are selectively activated so as to illuminate the electret layer only in the areas intended to form the surface potential patterns (M1).

4. The manufacturing method according to anyone of claims 1 to 3 in connection with step B2a, wherein the electret layer (E1) is made of a self-polarised organic dielectric material, so that step B1 consists in depositing the electret layer (E1) covering the array of diodes (10), the electret layer (E1) then having, over its entire surface, a non-zero initial surface potential.

5. The manufacturing method according to anyone of claims 1 to 3 in connection with step B2b, wherein the electret layer (E1) is made of a photochromic dielectric material, so that step B1 consists in depositing an electret layer (E1), made of the photochromic dielectric material, covering the array of diodes (10), the electret layer (E1) then having, over its entire surface, a zero surface potential.

6. The manufacturing method according to anyone of claims 1 to 3 in connection with step B2a, wherein the electret layer (E1) is made of a dielectric material, so that step B1 includes the following steps:
o depositing an electret later (E1), made of the dielectric material, covering the array of diodes (10), the electret layer (E1) then having, over its entire surface, a zero initial surface potential; then
o subjecting the electret layer (E1) to a predefined polarisation electric field, causing a formation of a non-zero surface potential over the entire surface of the electret layer (E1).

7. The manufacturing method according to the preceding claim, wherein:
o the array of diodes (10) includes an upper electrode layer (13) covering the diodes and configured to electrically polarise the diodes,
o during the step of subjecting the electret layer (E1) to the polarisation electric field, the electret layer (E1) is then arranged between the upper electrode layer (13) and an added-on electrode (14), between which a predefined potential difference is applied.

8. The manufacturing method according to anyone of claims 1 to 7, wherein:
o the electret layer (E1) made during step B is a first electret layer; and the photoluminescent pads (P1) made during step C are first photoluminescent pads configured to convert an incident light radiation with a first wavelength into a light radiation with a second wavelength different from the first wavelength;
o the method including the following steps, following step C:
o D/ making a second electret layer (E2), covering the array of diodes (10) and the first electret layer (E1), and an upper face (F1) of which, opposite to the array of diodes (10), has second predefined surface potential patterns (M2) where the surface potential is non-zero, said second surface potential patterns (M2) being located opposite diodes distinct from those opposite which the first surface potential patterns (M1) are located;
o E/ making the second photoluminescent pads (P2), by contact of the second electret layer (E2) with a colloidal solution containing second photoluminescent particles (p2), different from the first photoluminescent particles (p1) of step C, which are then deposited over the upper face (F2) of the second electret layer (E2) opposite the second predefined surface potential patterns (M2), thereby forming the second photoluminescent pads (P2).

9. The manufacturing method according to the preceding claim, wherein the diodes of the array (10) are light-emitting diodes configured to emit a light radiation at the same wavelength; and form with the first and second photoluminescent pads (P1, P2) an array of red, green, blue luminous pixels.

10. The manufacturing method according to anyone of claims 1 to 9, wherein the array of diodes (10) has a dimension, in a plane parallel to the array of diodes (10), larger than or equal to 100 mm.

11. The manufacturing method according to anyone of claims 1 to 10, wherein the array of diodes (10) has a pitch with a periodicity smaller than or equal to 10 µm, or 5 µm, or 2 µm.
